# EUROPEAN PATENT SPECIFICATION

(11) **EP 3 306 903 B1**
(45) Date of publication and mention of the grant of the patent: **13.03.2019**
(21) Application number: 17194264.2
(22) Date of filing: 29.09.2017
(51) Int. Cl.: H04M 1/02, G06F 1/16, B21D 22/02, B23C 3/12, B29C 45/14, B29K 705/00, B29L 31/34

(54) **A METHOD FOR FABRICATING A METAL SHELL, A METAL SHELL AND AN ELECTRONIC DEVICE**
VERFAHREN ZUR HERSTELLUNG EINER METALLSCHALE, METALLSCHALE UND ELEKTRONISCHE VORRICHTUNG
PROCÉDÉ DE FABRICATION D'UNE COQUE MÉTALLIQUE, COQUILLE MÉTALLIQUE ET DISPOSITIF ÉLECTRONIQUE

(30) Priority: 30.09.2016 WO PCT/CN2016/101060
(43) Date of publication of application: 11.04.2018
(73) Proprietor: Beijing Xiaomi Mobile Software Co., Ltd., Beijing 100085 (CN)
(72) Inventor: RAN, Jianbo, Haidian District, Beijing 100085 (CN); XU, Duo, Haidian District, Beijing 100085 (CN); WANG, Youfu, Haidian District, Beijing 100085 (CN)
(74) Representative: Sackin, Robert

(56) References cited:
- CN-A- 104 411 124
- US-A1- 2016 224 075

## Description

### TECHNICAL FIELD

The present disclosure generally relates to a field of electronic technology, and more particularly, to a method for fabricating a metal shell, a metal shell and an electronic device.

### BACKGROUND

In order to meet the tactile and visual experience of users, shells made of metal material are being adopted by more and more smartphones. In the related art, an integral forming process of a phone body (unibody process) is mainly that a whole piece of metal material is shaped into a metal shell having a basic shape, and then a large amount of computerized numerical control machines (CNC) are used for further shaping the metal shell into a specific shape. As the metal shell needs to be fixed through a plastic gripping structure after being shaped, and a thickness of the required metal material depends on a thickness of a position where the plastic gripping structure is located, accordingly, the thickness of the metal material could be greater than the thickness of the position where the plastic gripping structure is located, so that the metal material may be shaped. For example, if a side wall of the metal shell has a thickness of 0.9 mm and the plastic gripping structure has a thickness of 1.5 mm, the thickness of the required metal material is 2 mm, then the required metal material having the thickness of 2 mm is shaped by CNC. The whole metal material has a relatively great thickness, thus prolonging the time for CNC to cut material during shaping, as well as increasing the difficulty of stamp forming of the metal material.

CN104411124A discloses an electronic equipment assembly and a manufacturing method thereof. According to one specific embodiment, the method includes the following steps: processing a metal material into an outer frame of electronic equipment by a die casting and molding process; and forming a component in the outer frame during a die inner embedded element injection molding process.

US 20160224075A1 discloses a housing. The housing includes two base each having at least one sidewall, a gap defined between the two bases and a non-conductive member positioned in the gap, the sidewall has a plurality of grooves, the non-conductive member is filled into the grooves to enhance bonding strength between the non-conductive member and the two bases. An electronic device having the housing and a method of making the housing are also provided.

### SUMMARY

In order to overcome the problems existing in the related art, a method for fabricating a metal shell, a metal shell and an electronic device are provided by the present disclosure, so as to shorten the time for CNC to shave material during shaping, as well as reduce the difficulty of stamp forming of the metal material.

Aspects of the present invention are defined by the independent claims below to which reference should now be made. Optional features are defined by the dependent claims.

According to a first aspect of embodiments of the present disclosure, there is provided a method for fabricating a metal shell, including:
stamping out a side wall of the metal shell from the metal sheet, in which a reserved material is retained at a set position on the side wall;
bending and shoving the reserved material on the side wall towards an inner side of the side wall, until forming a protruding portion at the inner side of the side wall, in which the protruding portion has at least one plastic gripping hole;
removing an excessive material on the protruding portion to form an plastic gripping structure according to a preset shape of the plastic gripping structure; and
injecting the plastic gripping structure with plastic, so as to fill the plastic gripping structure up with the plastic;

In an exemplary embodiment, bending and shoving the reserved material on the side wall towards an inner side of the side wall, until forming a protruding portion at the inner side of the side wall includes:
placing a position limiting device at a position corresponding to the reserved material on a bottom portion of the metal shell;
bending and shoving the reserved material on the side wall towards the inner side of the side wall, until forming the protruding portion on a top of the position limiting device; and
limiting the protruding portion in the inner side of the side wall by using the top of the position limiting device, and removing the position limiting device.

In an exemplary embodiment, removing an excessive material on the protruding portion to form an plastic gripping structure according to a preset shape of the plastic gripping structure includes:
milling out a plastic gripping structure having an integral structure from the excessive material region on the protruding portion by using a computerized numerical control machine, according to the preset shape of the plastic gripping structure; and
processing the plastic gripping structure having the integral structure into two or more plastic gripping structures by using a T-shaped cutter, in which a hollow structure milled out by the T-shaped cutter is formed between the two or more plastic gripping structures.

In an exemplary embodiment, before the step of removing the excessive material on the protruding portion to form the plastic gripping structure, the method further includes:
milling out at least one plastic gripping hole on the surface of the protruding portion parallel to the bottom portion of the metal shell.

In an exemplary embodiment, after bending and shoving the reserved material on the side wall towards the inner side of the side wall, until forming the protruding portion at the inner side of the side wall, the method further includes:
milling out at least one plastic gripping hole on the reserved material of the metal sheet, in which the at least one plastic gripping hole is through the reserved material.

In an exemplary embodiment, after injecting the plastic gripping structure with plastic, the method further includes: dividing the metal shell into a border and a main body, filing an interspace between the border and the main body with the plastic again, to fix the border and the main body together.

According to a second aspect of embodiments of the present disclosure, there is provided a metal shell, including a side wall and a bottom portion; a plastic gripping structure is fixedly disposed on the side wall and the plastic gripping structure is formed by the method for fabricating a metal shell provided by the first aspect.

In an exemplary embodiment, the set position of the reserved material is determined by a slot, the reserved material has a size that enables itself to overlay the slot and extends at both sides parallel to the bottom portion along the side wall.

According to a third aspect of embodiments of the present disclosure, there is provided an electronic device, including:
a processor;
a memory for storing instructions executable by the processor;
in which, the electronic device has a metal shell including: a side wall and a bottom portion; a plastic gripping structure is fixedly disposed on the side wall and the plastic gripping structure is formed by the method for fabricating a metal shell provided by the first aspect.

Technical solutions provided by embodiments of the present may include the following beneficial effects:
Through the bending and shoving, moving, or pushing of the reserved material, the protruding portion is formed on the side wall, and then the required plastic gripping structure is fabricated through the protruding portion, avoiding the metal sheet from being stamped through CNC, as well as reducing the difficulty of stamp forming of the metal material, saving the time to process the metal shell and improving the production efficiency of the metal shell. In addition, as a thicker metal sheet is not used by the present disclosure, thus saving raw material of the metal sheet and reducing the cost.

It is to be understood that both the foregoing general description and the following detailed description are exemplary and explanatory only and are not restrictive of the invention, as claimed.

### BRIEF DESCRIPTION OF THE DRAWINGS

Fig. 1A is a flow chart showing a method for fabricating a metal shell, according to an exemplary embodiment.
Fig. 1B is a top view of a metal sheet used in Fig. 1A.
Fig. 1C is a partially schematic view of a side wall of the metal shell obtained through stamping in step 101 according to the embodiment shown in Fig. 1A.
Fig. ID is a schematic view of a protruding portion formed through bending and shoving in step 102 according to the embodiment shown in Fig. 1A.
Fig. IE is a schematic view of a plastic gripping structure with removal of pre-material in step 103 according to the embodiment shown in Fig. 1A.
Fig. 2 is a flow chart showing a method for fabricating a metal shell, according to an exemplary embodiment.
Fig. 3A is a flow chart showing a method for fabricating a metal shell, according to an exemplary embodiment.
Fig. 3B is a schematic view of a plastic gripping structure having an integral structure, according to the embodiment shown in Fig. 3A.
Fig. 3C is a schematic view showing that there are two plastic gripping structures, according to the embodiment shown in Fig. 3A.
Fig. 4A is a flow chart showing a method for fabricating a metal shell, according to an exemplary embodiment.
Fig. 4B is a partially schematic view of a plastic gripping structure having a plastic gripping hole, according to the embodiment shown in Fig. 4A.
Fig. 4C is another partially schematic view of the plastic gripping structure having the plastic gripping hole, according to the embodiment shown in Fig. 4A.
Fig. 4D is a schematic view showing that the shell injected with plastic is divided to form a metal border and a metal main body, according to the embodiment shown in Fig. 4A.
Fig. 5 is a schematic view of a metal shell, according to an exemplary embodiment.
Fig. 6 is a block diagram of an electronic device, according to an exemplary embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

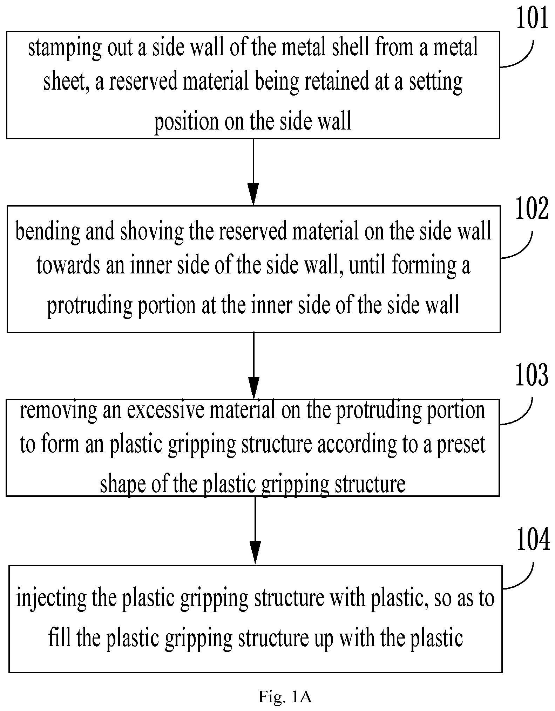

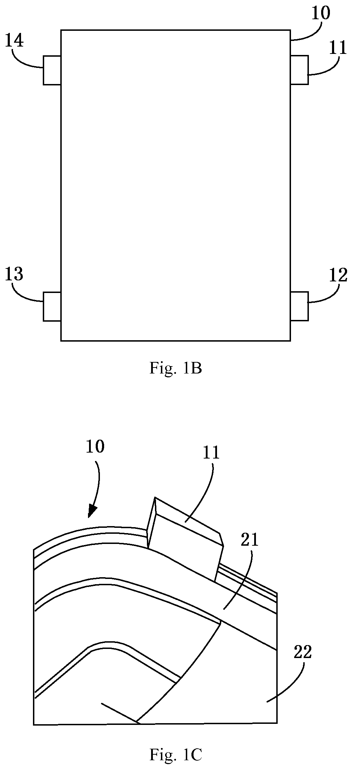

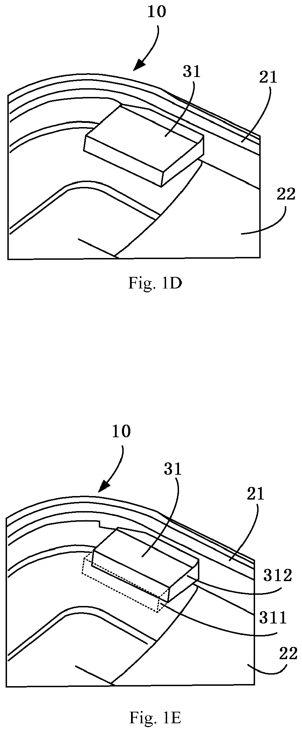

Fig. 1A is a flow chart of a method for fabricating a metal shell, according to an exemplary embodiment. Fig. 1B is a top view of a metal sheet used in Fig. 1A. Fig. 1C is a partially schematic view of a side wall of the metal shell obtained through stamping in step 101 according to the embodiment shown in Fig. 1A. Fig. 1D is a schematic view of a protruding portion formed through bending and shoving in step 102 according to the embodiment shown in Fig. 1A. Fig. IE is a schematic view of a plastic gripping structure with removal of an excessive material in step 103 according to the embodiment shown in Fig. 1A. The metal shell fabricated by the method may be applied to electronic devices (such as smart phones, tablets PCs, personal computers and the like devices). Referring to Fig. 1A, the method for fabricating a metal shell includes the following steps 101-105.

In step 101, a side wall of the metal shell is stamped out from a metal sheet, and a reserved material is retained at a set position on the side wall.

In an exemplary embodiment, in order to save the time to stamp a metal sheet 10 and reduce the complexity during the stamping, the metal sheet 10 may be a thinner one, such as a 0.9-mm-thick sheet. It would be understood by those skilled in the art that the present disclosure will not make a limit to the specific thickness of the metal sheet 10, as long as a longer time is not required to stamp the metal sheet and the complexity of a stamping machine may be reduced.

As shown in Fig. 1B, the set positions at both edges of the metal sheet are provided with a reserved material 11, a reserved material 12, a reserved material 13 and a reserved material 14. The set positions of the reserved materials 11-14 are determined by slots actually needed by an electronic device which the metal shell corresponds, the reserved materials 11-14 could have sizes that enable themselves to overlay the slots and could extend at both sides parallel to a bottom portion 22 along a side wall 21. For example, the slots may be configured to be an antenna slot. It would be understood by those skilled in the art that the present disclosure does not make a limit to specific functions of the slots, and any grooves which could be mounted on the metal shell and used for containing a certain circuit configuration may be deemed as the slots stated by the present disclosure.

In an exemplary embodiment, during the stamping, the side wall 21 and the bottom portion 22 may be stamped out from the metal sheet 10. After the stamping, the reserved material 11, the reserved material 12, the reserved material 13 and the reserved material 14 are disposed upright on the side wall 21. The reserved material 11 is taken as an example to illustrate the position and shape of the reserved material 11 on the side wall 21, the positions and shapes of the reserved material 12, the reserved material 13 and the reserved material 14 on the side wall 21 could refer to the description of the reserved material 11.

In step 102, the reserved material on the side wall is bent and shoved, moved or pushed towards an inner side of the side wall, until forming a protruding portion at the inner side of the side wall.

As shown in Fig. 1D, through bending and shoving, moving or pushing, a protruding portion 31 is formed on the inner side of the side wall 21 by squeezing the reserved material 11 and the side wall 21 under an external force.

In step 103, according to a preset shape of the plastic gripping structure, the excessive material on the protruding portion is removed, forming the plastic gripping structure.

As shown in Fig. IE, if the preset shape of the plastic gripping structure is rectangular, an excessive material 311 on the protruding portion 31 far away from the side wall and parallel to the bottom portion 22 may be removed from the protruding portion 31, forming a plastic gripping structure 312. It would be understood by those skilled in the art that the shape of the plastic gripping structure 312 may be designed according to an actual structure of an actual antenna slot and the like slots, and the specific shape of the plastic gripping structure 312 will not be limited by the present disclosure.

In step 104, the plastic gripping structure is injected with plastic, so as to fill the plastic gripping structure with the plastic.

In an exemplary embodiment, after being injected with the plastic, the plastic gripping structure 312 may have an insulated plastic surface layer, thereby avoiding the interference on the antenna and the like caused by the metal material.

In the present embodiment, through bending and shoving, moving or pushing the reserved material 11, the protruding portion 31 is formed on the side wall 21, and then the required plastic gripping structure 312 is made through the protruding portion 31. This avoids the metal sheet from being stamped through CNC, as well as reducing the difficulty of stamp forming of the metal material, saving the time to process the metal shell and improving the production efficiency of the metal shell. In addition, as a thicker metal sheet is not used by the present disclosure, raw material of the metal sheet is saved and the cost reduced.

In an exemplary embodiment, the step that the reserved material on the side wall is bent and crushed towards an inner side of the side wall, until forming the protruding portion at the inner side of the side wall may include:
placing a position limiting device at a position, corresponding to the reserved material, on the bottom portion of the metal shell;
bending and shoving, moving and pushing the reserved material on the side wall towards the inner side of the side wall, until forming the protruding portion on a top of the position limiting device; and
limiting the protruding portion in the inner side of the side wall by using the top of the position limiting device, and removing the position limiting device.

In an exemplary embodiment, the step that according to a preset shape of the plastic gripping structure, the excessive material on the protruding portion is removed, forming the plastic gripping structure may include:
according to the preset shape of the plastic gripping structure, milling out a plastic gripping structure having an integral structure from the excessive material on the protruding portion by using a computerized numerical control machine; and
processing the plastic gripping structure having the integral structure into two or more plastic gripping structures by using a T-shaped cutter, in which a hollow structure milled out by the T-shaped cutter is formed between the two or more plastic gripping structures.

In an exemplary embodiment, before the step of removing the excessive material on the protruding portion to form the plastic gripping structure, the method further includes:
milling out at least one plastic gripping hole on the surface of the protruding portion parallel to the bottom portion of the metal shell.

In an exemplary embodiment, after the step of bending and shoving, moving or pushing the reserved material on the side wall towards the inner side of the side wall, until forming the protruding portion at the inner side of the side wall, the method further includes:
milling out at least one plastic gripping hole on the reserved material of the metal sheet, in which the at least one of the plastic gripping hole runs through the reserved material.

Concerning how to fabricate the metal shell, the following embodiments could be referred to.

So far, the method provided by embodiments of the present disclosure could avoid the metal sheet from being stamped through CNC, as well as reduce the difficulty of stamp forming of the metal material, save the time to process the metal shell and improve the production efficiency of the metal shell.

The technical solution provided by embodiments of the present disclosure will be described with reference to specific embodiments.

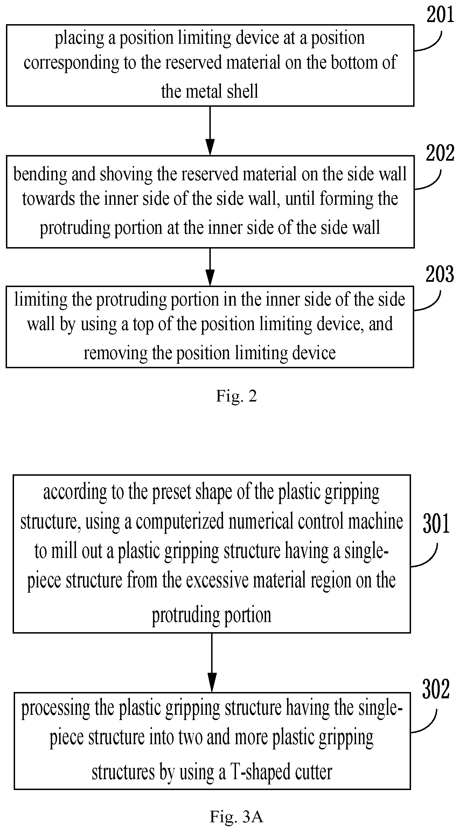

Fig. 2 is a flow chart showing a method for fabricating a metal shell, according to another exemplary embodiment. The present embodiment will use the above method provided by embodiments of the present disclosure to make an exemplary description by taking how to bend and shove the reserved material as an example and accompanying with Fig. 1C and Fig. 1D, as shown in Fig. 2, the method in the present embodiment may include the following steps.

In step 201, the position limiting device is placed at the position corresponding to the reserved material on the bottom portion of the metal shell.

In step 202, the reserved material on the side wall is bent and shoved, moved or pushed towards the inner side of the side wall, until forming the protruding portion at the inner side of the side wall.

In step 203, the protruding portion is limited in the inner side of the side wall by using the top of the position limiting device, and the position limiting device is removed.

As shown in Figs. 1C and 1D, a height of the position limiting device may be determined according to the position of the protruding portion 21 at the inner side of the side wall 21. The present disclosure will not make a limit to a shape of the position limiting device, which may be configured as a cuboid, and a height of the cuboid is for defining the distance between protruding portion 31 and the bottom portion 22.

In the present embodiment, through the position limiting device, the position of the protruding portion 31 formed by bending and shoving, moving or pushing the reserved material 11 on the side wall 21 may be flexibly controlled, avoiding improper positions of the protruding portion 21 on the side wall 21 resulted from a poor force used during the shoving, moving or pushing, improving the yield rate of the metal shell during the fabricating process.

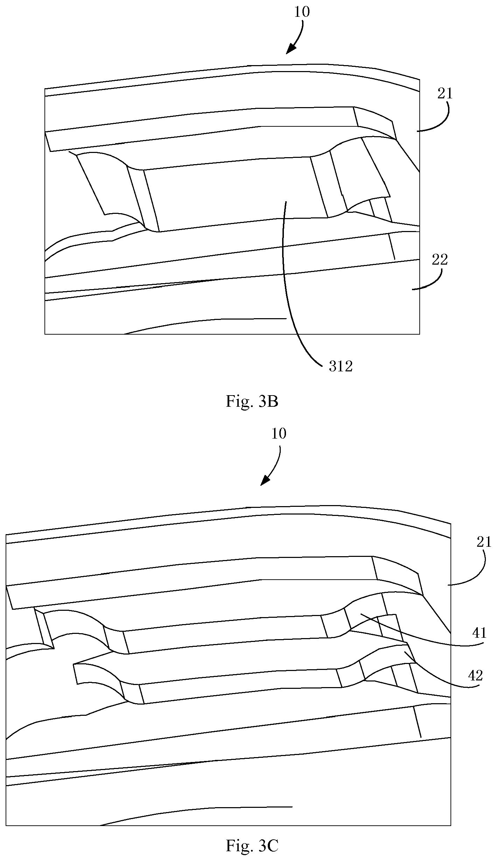

Fig. 3A is a flow chart showing a method for fabricating a metal shell according to a further exemplary embodiment. Fig. 3B is a schematic view of the plastic gripping structure having an integral structure according to the embodiment shown in Fig. 3A. Fig. 3C is a schematic view showing that there are two plastic gripping structures according to the embodiment shown in Fig. 3A. The present embodiment will use the above method provided by embodiments of the present disclosure to make an exemplary description by taking how to mill the protruding portion into two or more plastic gripping structures as an example, as shown in Fig. 3A, the method in the present embodiment may include the following steps.

In step 301, according to the preset shape of the plastic gripping structure, a computerized numerical control machine is used to mill out a plastic gripping structure having an integral structure from the excessive material region on the protruding portion.

In step 302, the plastic gripping structure having an integral structure is processed into two or more plastic gripping structures by using a T-shaped cutter, in which a hollow structure milled out by the T-shaped cutter is formed between the two or more plastic gripping structures.

In step 301, in an exemplary scene, if the preset shape of the plastic gripping structure is the shape shown in Fig. 3B, the plastic gripping structure 312 has an integral structure.

In step 302, in an exemplary scene, if the preset shape of the plastic gripping structure is the shape shown in Fig. 3C, the integral plastic gripping structure shown in Fig. 3B may be cut by the T-shaped cutter, forming a plastic gripping structure 41 and a plastic gripping structure 42. It could be understood by those skilled in the art that, the present disclosure just takes the plastic gripping structure without the milled plastic gripping hole as an example to make the exemplary description. When the plastic gripping structure is provided with the plastic gripping hole, similarly, the integral plastic gripping structure may be processed into two or more plastic gripping structures through the T-shaped cutter and the method process according to embodiments of the present disclosure.

In the present embodiment, by processing the integral plastic gripping structure into two or more plastic gripping structures, the contacting area between the plastic gripping structure and the plastic may be increased in multiples, improving the firmness.

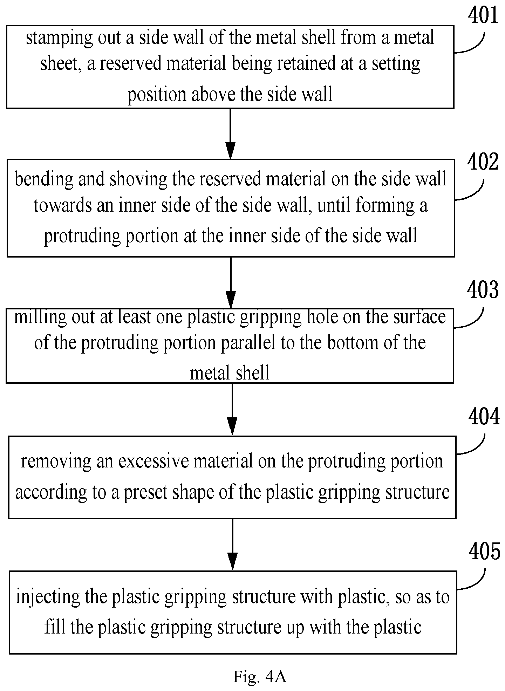

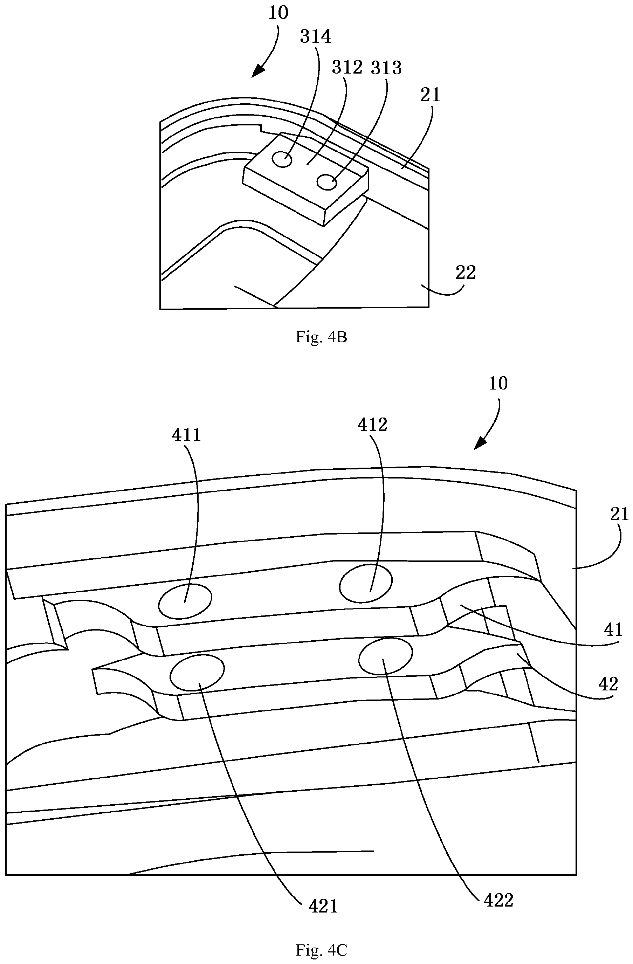

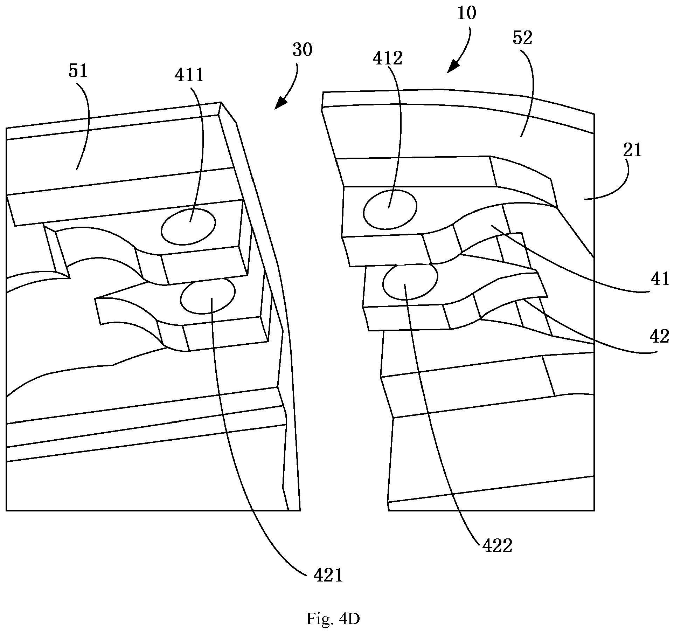

Fig. 4A is a flow chart showing a method for fabricating a metal shell according to an additional exemplary embodiment. Fig. 4B is a partially schematic view of a plastic gripping structure having a plastic gripping hole according to the embodiment shown in Fig. 4A. Fig. 4C is another partially schematic view of the plastic gripping structure having the plastic gripping hole according to the embodiment shown in Fig. 4A. Fig. 4D is a schematic view showing that the shell injected with plastic is divided to form a metal border and a metal main body according to the embodiment shown in Fig. 4A. The present embodiment will use the above method provided by embodiments of the present disclosure to make an exemplary description by taking how to mill out the plastic gripping hole on the plastic gripping structure and remove the excessive material as an example, as shown in Fig. 4A, the method in the present embodiment may include the following steps

In step 401, the side wall of the metal shell is stamped out from the metal sheet, and the reserved material is retained at the set position on the side wall.

In step 402, the reserved material on the side wall are bent and shoved, moved or pushed towards the inner side of the side wall, until forming the protruding portion at the inner side of the side wall.

The descriptions of step 401 and step 402 may refer to the relevant descriptions according to embodiments shown in Fig. 1A, which will not be elaborated herein.

In step 403, at least one plastic gripping hole is milled out on the surface of the protruding portion parallel to the bottom portion of the metal shell.

As shown in Fig. 4B, on the surface of the protruding portion 31 parallel to the bottom portion 22, two plastic gripping holes 314 and 313 may be milled out. Through the two plastic gripping holes 314 and 313, the contacting area with the plastic when injecting the plastic gripping structure 312 with the plastic subsequently may be increased, improving the firmness of the plastic gripping structure 312.

In Fig. 4C, according to embodiments shown in Fig. 3A, the protruding portion 31 is formed into two plastic gripping structures, i.e. a plastic gripping structure 41 and a plastic gripping structure 42 respectively. A plastic gripping hole 411 and a plastic gripping hole 412 are milled out on the plastic gripping structure 41, while a plastic gripping hole 421 and a plastic gripping hole 422 are milled out on the plastic gripping structure 42.

In step 404, according to the preset shape of the plastic gripping structure, the excessive material on the protruding portion is removed.

As sizes and positions of the antenna slots in different metal shells are different, the shapes of the plastic gripping structures are also different. Accordingly, in arrangements of the present disclosure, the excessive material on the protruding portion 31 may be removed according to preset shapes of plastic gripping structures, thereby forming different plastic gripping structures. In an embodiment, the descriptions of removal of the excessive material may refer to the descriptions according to embodiments shown in Fig. 1A, which will not be elaborated herein.

In step 405, the plastic gripping structure is injected with the plastic, so as to fill up the plastic gripping structure with the plastic.

As shown in Fig. 4D, when the plastic gripping structure shown in Fig. 4C is injected with the plastic, the plastic gripping hole 411, the plastic gripping hole 412, the plastic gripping hole 421 and the plastic gripping hole 422 are all filled up with the plastic. When dividing the shell after injecting the plastic, a border 51 of the metal shell and a main body 52 of the metal shell may be formed. An interspace or space 30 between the border 51 and the main body 52 may be filled with the plastic again, thereby fixing the border 51 and the main body 52 together.

On basis of beneficial technical effects of the embodiment shown in Fig. 1A, through the plastic gripping hole 314 and the plastic gripping hole 313, the present embodiment may increase the contact area with the plastic when injecting the plastic gripping structure 312 with the plastic, improving the firmness of the plastic gripping structure 312.

As an alternative embodiment, on basis of the embodiment shown in Fig. 4A, before executing step 401 and stamping the metal sheet 10, the plastic gripping hole 314 and the plastic gripping hole 313 as shown in Fig. 4B may be milled out on the reserved material 11, in which the plastic gripping hole 314 and the plastic gripping hole 313 runs through the reserved material 11. Likewise, according to actual design requirements of the metal shell, the plastic gripping holes may be milled out on the reserved material 12, the reserved material 13 and the reserved material 14 by the same way with those of the reserved material 11. Afterwards, subsequent step 401, step 402 and step 404 may be executed.

Before stamping the metal sheet 10, the metal sheet 10 may spread in a horizontal direction on an operating station of a device, thereby facilitating milling out the plastic gripping hole on the reserved material, reducing the complexity of processing the plastic gripping hole.

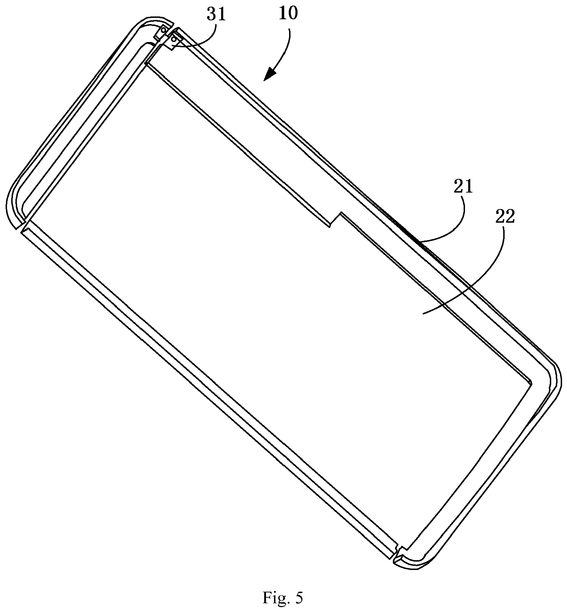

Fig. 5 is a schematic view of a metal shell, according to an exemplary embodiment. As shown in Fig. 5, the metal sheet 10 includes: the side wall 21 and the bottom portion 22. The plastic gripping structure 312 is fixedly disposed on the side wall 21, in which the plastic gripping structure 312 is formed by the method for fabricating a metal shell provided by the above embodiments.

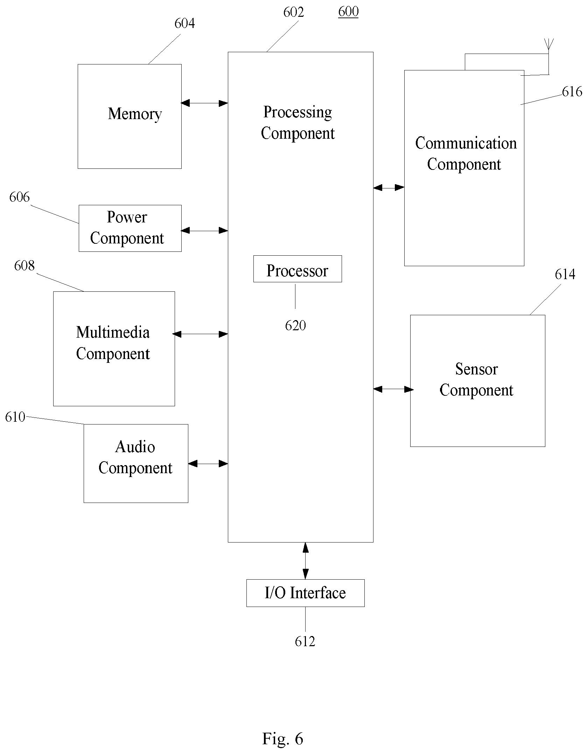

Fig. 6 is a block diagram of an electronic device 600 according to an exemplary embodiment. For example, the device 600 may be a mobile phone, a computer, a digital broadcast terminal, a messaging device, a gaming console, a tablet, a medical device, exercise device, a personal digital assistant, and the like. The electronic device 600 has the metal shell as shown in Fig. 5.

Referring to Fig. 6, the device 600 may include one or more of the following components: a processing component 602, a memory 604, a power component 606, a multimedia component 608, an audio component 610, an input/output (I/O) interface 612, a sensor component 614, and a communication component 616.

The processing component 602 typically controls overall operations of the device 600, such as the operations associated with display, telephone calls, data communications, camera operations, and recording operations. The processing component 602 may include one or more processors 620 to execute instructions to perform all or part of the steps in the above described methods. Moreover, the processing component 602 may include one or more modules which facilitate the interaction between the processing component 602 and other components. For instance, the processing component 602 may include a multimedia module to facilitate the interaction between the multimedia component 608 and the processing component 602.

The memory 604 is configured to store various types of data to support the operation of the device 600. Examples of such data include instructions for any applications or methods operated on the device 600, contact data, phonebook data, messages, pictures, video, etc. The memory 604 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 606 provides power to various components of the device 600. The power component 606 may include a power management system, one or more power sources, and any other components associated with the generation, management, and distribution of power in the device 600.

The multimedia component 608 includes a screen providing an output interface between the device 600 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 608 includes a front camera and/or a rear camera. The front camera and the rear camera may receive an external multimedia datum while the device 600 is in an operation mode, such as a photographing mode or a video mode. Each of the front camera and the rear camera may be a fixed optical lens system or have focus and optical zoom capability.

The audio component 610 is configured to output and/or input audio signals. For example, the audio component 610 includes a microphone (MIC) configured to receive an external audio signal when the device 600 is in an operation mode, such as a call mode, a recording mode, and a voice recognition mode. The received audio signal may be further stored in the memory 604 or transmitted via the communication component 616. In some embodiments, the audio component 610 further includes a speaker to output audio signals.

The I/O interface 612 provides an interface between the processing component 602 and peripheral interface modules, such as a keyboard, a click wheel, buttons, and the like. The buttons may include, but are not limited to, a home button, a volume button, a starting button, and a locking button.

The sensor component 614 includes one or more sensors to provide status assessments of various aspects of the device 600. For instance, the sensor component 614 may detect an open/closed status of the device 600, relative positioning of components, e.g., the display and the keypad, of the device 800, a change in position of the device 600 or a component of the device 600, a presence or absence of user contact with the device 600, an orientation or an acceleration/deceleration of the device 600, and a change in temperature of the device 600. The sensor component 614 may include a proximity sensor configured to detect the presence of nearby objects without any physical contact. The sensor component 614 may also include a light sensor, such as a CMOS or CCD image sensor, for use in imaging applications. In some embodiments, the sensor component 614 may also include an accelerometer sensor, a gyroscope sensor, a magnetic sensor, a pressure sensor, or a temperature sensor.

The communication component 616 is configured to facilitate communication, wired or wirelessly, between the device 600 and other devices. The device 600 can access a wireless network based on a communication standard, such as WiFi, 2G, or 3G, or a combination thereof. In one exemplary embodiment, the communication component 616 receives a broadcast signal or broadcast associated information from an external broadcast management system via a broadcast channel. In one exemplary embodiment, the communication component 616 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the device 600 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the above described methods.

In exemplary embodiments, there is also provided a non-transitory computer-readable storage medium including instructions, such as included in the memory 604. For example, the non-transitory computer-readable storage medium may be a ROM, a RAM, a CD-ROM, a magnetic tape, a floppy disc, an optical data storage device, and the like.

Other embodiments of the invention will be apparent to those skilled in the art from consideration of the specification and practice of the invention disclosed here. This application is intended to cover any variations, uses, or adaptations of the invention following the general principles thereof and including such departures from the present disclosure as come within known or customary practice in the art.

## Claims

1. A method for fabricating a metal shell, **characterized in that** the method comprises:
stamping out a side wall (21) of the metal shell from a metal sheet (10), a reserved material (11, 12, 13, 14) being retained at a set position on the side wall (21);
bending and moving the reserved material (11, 12, 13, 14) on the side wall (21) towards an inner side of the side wall (21), until forming a protruding portion (31) at the inner side of the side wall (21), the protruding portion (31) having at least one plastic gripping hole (313, 314, 411, 412, 421, 422);
removing an excessive material (311) on the protruding portion (31) to form a plastic gripping structure (312, 41, 42) according to a preset shape of the plastic gripping structure (312, 41, 42); and
injecting the plastic gripping structure (312, 41, 42) with plastic, so as to fill the plastic gripping structure (312, 41, 42) with the plastic.

2. The method of claim 1, wherein bending and moving the reserved material (11, 12, 13, 14) on the side wall (21) towards an inner side of the side wall (21), until forming a protruding portion (31) at the inner side of the side wall (21) comprises:
placing a position limiting device at a position, corresponding to the reserved material (11, 12, 13, 14), on a bottom portion (22) of the metal shell;
bending and moving the reserved material (11, 12, 13, 14) on the side wall (21) towards the inner side of the side wall (21), until forming the protruding portion (31) on a top of the position limiting device; and
limiting the protruding portion (31) in the inner side of the side wall (21) by using the top of the position limiting device, and removing the position limiting device.

3. The method of claim 1 or claim 2, wherein removing the excessive material (311) on the protruding portion (31) to form an plastic gripping structure (312, 41, 42) according to a preset shape of the plastic gripping structure (312, 41, 42) comprises:
milling out a plastic gripping structure (312) having an integral structure from the excessive material (311) on the protruding portion (31) by using a computerized numerical control machine, according to the preset shape of the plastic gripping structure (312); and
processing the plastic gripping structure (312) having the integral structure into two or more plastic gripping structures (41, 42) by using a T-shaped cutter, a hollow structure milled out by the T-shaped cutter being formed between the two or more plastic gripping structures (41, 42).

4. The method of any preceding claim, wherein before removing the excessive material (311) on the protruding portion (31) to form the plastic gripping structure (312, 41, 42), the method further comprises:
milling out at least one plastic gripping hole (313, 314, 411, 412, 421, 422) on the surface of the protruding portion (31) parallel to the bottom portion (21) of the metal shell.

5. The method of any preceding claim, wherein after bending and moving the reserved material (11, 12, 13, 14) on the side wall (21) towards the inner side of the side wall (21), until forming the protruding portion (31) at the inner side of the side wall (21), the method further comprises:
milling out at least one plastic gripping hole (313, 314, 411, 412, 421, 422) on the reserved material (11, 12, 13, 14) of the metal sheet, the at least one plastic gripping hole (313, 314, 411, 412, 421, 422) running through the reserved material (11, 12, 13, 14).

6. The method of any preceding claim, wherein after injecting the plastic gripping structure (312, 41, 42) with plastic, the method further comprises:
dividing the metal shell into a border (51) and a main body (52), filling an interspace (30) between the border (51) and the main body (52) with the plastic again, to fix the border (51) and the main body (52) together.

7. A metal shell, comprising a side wall (21) and a bottom portion (22), **characterized in that** a plastic gripping structure (312, 41, 42) is fixedly disposed on the side wall (21), the plastic gripping structure (312, 41, 42) is formed by any of claims 1 to 6.

8. The metal shell of claim 7, wherein the set position of the reserved material (11, 12, 13, 14) is determined by a slot, the reserved material (11, 12, 13, 14) has a size that enables itself to overlay the slot and extends at both sides parallel to the bottom portion (22) along the side wall (21).

9. An electronic device (600), comprising:
a processor (620);
a memory (604) for storing instructions executable by the processor (620);
wherein the electronic device (600) has a metal shell, comprising a side wall (21) and a bottom portion (22), **characterized in that** a plastic gripping structure (312, 41, 42) is fixedly disposed on the side wall (21) and the plastic gripping structure (312, 41, 42) is formed by any of claims 1 to 6.

## Patentansprüche

1. Verfahren zum Anfertigen einer Metallhülle, **dadurch gekennzeichnet, dass** das Verfahren Folgendes aufweist:
Ausstanzen einer Seitenwand (21) der Metallhülle aus einem Blech (10), wobei ein reserviertes Material (11, 12, 13, 14) an einer vorgegebenen Position an der Seitenwand (21) zurückbehalten wird;
Biegen und Bewegen des reservierten Materials (11, 12, 13, 14) an der Seitenwand (21) in Richtung auf eine Innenseite der Seitenwand (21), bis an der Innenseite der Seitenwand (21) ein vorstehender Teil (31) geformt wird, wobei der vorstehende Teil (31) wenigstens ein Plastikgreifloch (313, 314, 411, 412, 421, 422) hat;
Entfernen von überschüssigem Material (311) am vorstehenden Teil (31) zum Formen einer Plastikgreifstruktur (312, 41, 42) gemäß einer vorgegebenen Form der Plastikgreifstruktur (312, 41, 42) und
Einspritzen von Plastik in die Plastikgreifstruktur (312, 41, 42), um die Plastikgreifstruktur (312, 41, 42) mit dem Plastik zu füllen.

2. Verfahren nach Anspruch 1, wobei das Biegen und Bewegen des reservierten Materials (11, 12, 13, 14) an der Seitenwand (21) in Richtung auf eine Innenseite der Seitenwand (21), bis an der Innenseite der Seitenwand (21) ein vorstehender Teil (31) geformt wird, Folgendes aufweist:
Setzen einer Positionsbegrenzungsvorrichtung auf eine Position, die dem reservierten Material (11, 12, 13, 14) entspricht, an einem Unterteil (22) der Metallhülle;
Biegen und Bewegen des reservierten Materials (11, 12, 13, 14) an der Seitenwand (21) in Richtung auf die Innenseite der Seitenwand (21), bis der vorstehende Teil (31) an einem oberen Ende der Positionsbegrenzungsvorrichtung geformt wird; und
Begrenzen des vorstehenden Teils (31) in der Innenseite der Seitenwand (21) mithilfe des oberen Endes der Positionsbegrenzungsvorrichtung und Entfernen der Positionsbegrenzungsvorrichtung.

3. Verfahren nach Anspruch 1 oder Anspruch 2, wobei das Entfernen des überschüssigen Materials (311) am vorstehenden Teil (31) zum Formen einer Plastikgreifstruktur (312, 41, 42) gemäß einer vorgegebenen Form der Plastikgreifstruktur (312, 41, 42) Folgendes aufweist:
Herausfräsen einer Plastikgreifstruktur (312), die eine einstückige Struktur hat, aus dem überschüssigen Material (311) am vorstehenden Teil (31) mithilfe einer Maschine mit computergestützter numerischer Steuerung gemäß der vorgegebenen Form der Plastikgreifstruktur (312) und
Verarbeiten der Plastikgreifstruktur (312), die die einstückige Struktur hat, zu zwei oder mehr Plastikgreifstrukturen (41, 42) mithilfe eines T-förmigen Fräsers, wobei zwischen den zwei oder mehr Plastikgreifstrukturen (41, 42) eine durch den T-förmigen Fräser herausgefräste hohle Struktur geformt wird.

4. Verfahren nach einem der vorhergehenden Ansprüche, wobei das Verfahren vor dem Entfernen des überschüssigen Materials (311) am vorstehenden Teil (31) zum Formen der Plastikgreifstruktur (312, 41, 42) Folgendes aufweist:
Herausfräsen wenigstens eines Plastikgreiflochs (313, 314, 411, 412, 421, 422) an der Oberfläche des vorstehenden Teils (31) parallel zum Unterteil (21) der Metallhülle.

5. Verfahren nach einem der vorhergehenden Ansprüche, wobei das Verfahren nach dem Biegen und Bewegen des reservierten Materials (11, 12, 13, 14) an der Seitenwand (21) in Richtung auf die Innenseite der Seitenwand (21), bis der vorstehende Teil (31) an der Innenseite der Seitenwand (21) geformt wird, ferner Folgendes aufweist:
Herausfräsen wenigstens eines Plastikgreiflochs (313, 314, 411, 412, 421, 422) an dem reservierten Material (11, 12, 13, 14) des Blechs, wobei das wenigstens eine Plastikgreifloch (313, 314, 411, 412, 421, 422) durch das reservierte Material (11, 12, 13, 14) verläuft.

6. Verfahren nach einem der vorhergehenden Ansprüche, wobei das Verfahren nach dem Einspritzen von Plastik in die Plastikgreifstruktur (312, 41, 42) ferner Folgendes aufweist:
Teilen der Metallhülle in einen Rand (51) und einen Hauptkörper (52), Füllen eines Zwischenraums (30) zwischen dem Rand (51) und dem Hauptkörper (52) wieder mit dem Plastik, um den Rand (51) und den Hauptkörper (52) aneinander zu befestigen.

7. Metallhülle, die eine Seitenwand (21) und einen Unterteil (22) aufweist, **dadurch gekennzeichnet, dass** eine Plastikgreifstruktur (312, 41, 42) fest an der Seitenwand (21) angeordnet ist, wobei die Plastikgreifstruktur (312, 41, 42) nach einem der Ansprüche 1 bis 6 geformt wird.

8. Metallhülle nach Anspruch 7, wobei die vorgegebene Position des reservierten Materials (11, 12, 13, 14) von einer Aussparung bestimmt wird, wobei das reservierte Material (11, 12, 13, 14) eine Größe hat, die es ermöglicht die Aussparung zu überlagern und die sich an beiden Seiten parallel zum Unterteil (22) an der Seitenwand (21) entlang erstreckt.

9. Elektronische Vorrichtung (600), die Folgendes aufweist:
einen Prozessor (620);
einen Speicher (604) zum Speichern von durch den Prozessor (620) ausführbaren Anweisungen;
wobei die elektronische Vorrichtung (600) eine Metallhülle hat, die eine Seitenwand (21) und einen Unterteil (22) aufweist, **dadurch gekennzeichnet, dass** eine Plastikgreifstruktur (312, 41, 42) fest an der Seitenwand (21) angeordnet ist und die Plastikgreifstruktur (312, 41, 42) nach einem der Ansprüche 1 bis 6 geformt wird.

## Revendications

1. Procédé de fabrication d'une coque métallique, **caractérisé en ce que** le procédé comprend :
la formation par estampage d'une feuille de métal (10) d'une paroi latérale (21) de la coque métallique, un matériau réservé (11, 12, 13, 14) étant retenu à une position établie sur la paroi latérale (21) ;
la flexion et le déplacement du matériau réservé (11, 12, 13, 14) sur la paroi latérale (21) vers un côté interne de la paroi latérale (21), jusqu'à la formation d'une partie saillante (31) au niveau du côté interne de la paroi latérale (21), la partie saillante (31) ayant au moins un trou de saisie en plastique (313, 314, 411, 412, 421, 422) ;
le retrait d'un excédent de matériau (311) sur la partie saillante (31) pour former une structure de saisie en plastique (312, 41, 42) conformément à une forme préétablie de la structure de saisie en plastique (312, 41, 42) ; et
l'injection de plastique dans la structure de saisie en plastique (312, 41, 42), de manière à remplir de plastique la structure de saisie en plastique (312, 41, 42).

2. Procédé selon la revendication 1, dans lequel la flexion et le déplacement du matériau réservé (11, 12, 13, 14) sur la paroi latérale (21) vers un côté interne de la paroi latérale (21), jusqu'à la formation d'une partie saillante (31) au niveau du côté interne de la paroi latérale (21) comprend :
le placement d'un dispositif de limitation de position à une position, correspondant au matériau réservé (11, 12, 13, 14), sur une partie de fond (22) de la coque métallique ;
la flexion et le déplacement du matériau réservé (11, 12, 13, 14) sur la paroi latérale (21) vers un côté interne de la paroi latérale (21), jusqu'à la formation de la partie saillante (31) sur une partie haute du dispositif de limitation de position ; et
la limitation de la partie saillante (31) dans le côté interne de la paroi latérale (21) en utilisant la partie haute du dispositif de limitation de position, et le retrait du dispositif de limitation de position.

3. Procédé selon la revendication 1 ou la revendication 2, dans lequel le retrait de l'excédent de matériau (311) sur la partie saillante (31) pour former une structure de saisie en plastique (312, 41, 42) conformément à une forme préétablie de la structure de saisie en plastique (312, 41, 42) comprend :
la formation par fraisage d'une structure de saisie en plastique (312) ayant une structure intégrale à partir de l'excédent de matériau (311) sur la partie saillante (31) au moyen d'une machine de commande numérisée informatisée, conformément à la forme préétablie de la structure de saisie en plastique (312) ; et
le traitement de la structure de saisie en plastique (312) de structure intégrale pour former deux ou plusieurs structures de saisie en plastique (41, 42) au moyen d'un outil de coupe en forme de T, une structure creuse étant formée par fraisage par l'outil de coupe en forme de T entre les deux ou plusieurs structures de saisie en plastique (41, 42).

4. Procédé selon l'une quelconque des revendications précédentes, comprenant en outre, avant le retrait de l'excédent de matériau (311) sur la partie saillante (31) pour former la structure de saisie en plastique (312, 41, 42) :
la formation par fraisage d'au moins un trou de saisie en plastique (313, 314, 411, 412, 421, 422) sur la surface de la partie saillante (31) parallèle à la partie de fond (21) de la coque métallique.

5. Procédé selon l'une quelconque des revendications précédentes, comprenant en outre après la flexion et le déplacement du matériau réservé (11, 12, 13, 14) sur la paroi latérale (21) vers le côté interne de la paroi latérale (21), jusqu'à la formation de la partie saillante (31) au niveau du côté interne de la paroi latérale (21) :
la formation par fraisage d'au moins un trou de saisie en plastique (313, 314, 411, 412, 421, 422) sur le matériau réservé (11, 12, 13, 14) de la feuille métallique, l'au moins un trou de saisie en plastique (313, 314, 411, 412, 421, 422) traversant le matériau réservé (11, 12, 13, 14).

6. Procédé selon l'une quelconque des revendications précédentes, comprenant en outre après l'injection de plastique dans la structure de saisie en plastique (312, 41, 42) :
la division de la coque métallique en une bordure (51) et un corps principal (52), en remplissant de plastique à nouveau un espace intermédiaire (30) entre la bordure (51) et le corps principal (52), pour fixer ensemble la bordure (51) et le corps principal (52).

7. Coque métallique, comprenant une paroi latérale (21) et une partie de fond (22), **caractérisée en ce qu'**une structure de saisie en plastique (312, 41, 42) est disposée de manière fixe sur la paroi latérale (21), la structure de saisie en plastique (312, 41, 42) étant formée selon l'une quelconque des revendications 1 à 6.

8. Coque métallique selon la revendication 7, dans laquelle la position établie du matériau réservé (11, 12, 13, 14) est déterminée par une fente, le matériau réservé (11, 12, 13, 14) ayant une taille qui lui permet de recouvrir la fente et s'étendant au niveau des deux côtés parallèles à la partie de fond (22) le long de la paroi latérale (21).

9. Dispositif électronique (600), comprenant :
un processeur (620) ;
une mémoire (604) destinée à mémoriser des instructions exécutables par le processeur (620) ;
le dispositif électronique (600) présentant une coque métallique, comprenant une paroi latérale (21) et une partie de fond (22), **caractérisé en ce qu'**une structure de saisie en plastique (312, 41, 42) est disposée de manière fixe sur la paroi latérale (21) et la structure de saisie en plastique (312, 41, 42) est formée selon l'une quelconque des revendications 1 à 6.
